(19) Europäisches Patentamt
European Patent Office
Office européen des brevets

(11) Veröffentlichungsnummer: **0 359 743 B1**

(12) # EUROPÄISCHE PATENTSCHRIFT

(45) Veröffentlichungstag der Patentschrift:
15.05.91 Patentblatt 91/20

(51) Int. Cl.$^5$: **G11C 8/00, G11C 11/412,**
**G11C 11/418, G11C 11/419**

(21) Anmeldenummer: 88902793.4

(22) Anmeldetag: 25.03.88

(86) Internationale Anmeldenummer:
PCT/DE88/00195

(87) Internationale Veröffentlichungsnummer:
WO 88/09037 17.11.88 Gazette 88/25

(54) CMOS-RAM SPEICHER AUF EINER GATE ARRAY-ANORDNUNG.

(30) Priorität: 04.05.87 DE 3714813

(43) Veröffentlichungstag der Anmeldung:
28.03.90 Patentblatt 90/13

(45) Bekanntmachung des Hinweises auf die
Patenterteilung:
15.05.91 Patentblatt 91/20

(84) Benannte Vertragsstaaten:
DE FR GB IT SE

(56) Entgegenhaltungen:
EP-A- 0 224 887
DE-A- 3 206 507
GB-A- 2 159 359
US-A- 4 063 225
US-A- 4 112 506

(56) Entgegenhaltungen:
IBM Technical Disclosure Bulletin, vol. 29, no.
5, October 1986, (New York, US), "Two-stage
decoder for static RAMs", pages 2306 - 2307
IEEE Journal of Solid-States Circuits, vol.
SC-20, no. 5, October 1985, IEEE, (New York,
US), S. Yamamoto et al., "A 256K CMOS SRAM
with variable impedance data-line loads", pages 924 - 928
IEEE Journal of Solid-State Circuits, Bd SC-20,
No. 5, October 1985, (New York, USA), Taka
Nashi et al., "A 240K transistor CMOS array
with flexible allocation of memory and channels", pages 1012 - 1017

(73) Patentinhaber: Siemens Aktiengesellschaft
Wittelsbacherplatz 2
W-8000 München 2 (DE)

(72) Erfinder: KARETSOS, Anastasios
Frühlingstra e 4
W-8038 Gröbenzell (DE)
Erfinder: ZWILLING, Gerhard
Regerstra e 12
W-8000 München 90 (DE)

## Beschreibung

Die Erfindung bezieht sich auf einen CMOS-RAM Speicher auf einer Gate Array-Anordnung, die eine Matrix aus Grundzellen aufweist.

Gate Array Anordnungen sind bekannt (z.B. Hitachi Review Vol. 33 (1984) Nr. 5, S. 261-266). Bei solchen Gate Array Anordnungen werden auf einem Chip Bereiche in bestimmter Anordnung vorgesehen, auf denen Grundzellen realisiert sind. Die Grundzellen bestehen aus N-Kanal- und P-Kanaltransistoren, die in bestimmter Weise in den Bereichen angeordnet sind. Durch Verbindung der N- und P-Kanaltransistoren pro Grundzelle kann die Grundzelle zur Realisierung einer Grundfunktion spezifiziert werden und ihr z.B. eine logische Funktion oder eine Speicherfunktion gegeben werden. Aus Hitachi Review, die oben zitiert worden ist, ergibt sich, daß eine Grundzelle z.B. aus 10 Transistoren bestehen kann, die so miteinander verbunden werden, daß eine RAM-Speicher Zelle mit einem Eingang oder zwei Eingängen entsteht. Durch andere Verbindungen der Transistoren in einer Grundzelle kann z.B. eine logische Funktion, z.B. eine NAND-Funktion realisiert werden.

Aus IEEE Journal of Solid-State Circuits, Band SC-20, Nr.5, Oktober 1985, New York, USA, Takahashi et al. : A 240 K transistor CMOS array with flexible allocation of memory and channels", Seiten 1012-1017, ergibt sich eine Gate-Array Anordnung aus Grundzellen, wobei die Grundzellen acht Transistorzellen sind. Die Grundzellen sind auf einem Chip in einer Matrix angeordnet. Ein Teil dieser Grundzellen kann zur Realisierung eines RAM Speichers verwendet werden, wobei die einzelnen Speicherzellen aus 6 Transistoren bestehen. Die genaue Anordnung der Speicherzellen und die Anordnung von Peripherieschaltungen des Speichers sind nicht dargestellt.

Aus DE 3206 507 Al ist bekannt, Speicherzellen aus Speicherelementen mit rückgekoppelten Invertern und zwei Ansteuertransistoren aufzubauen.

Die GB 2 159 359 A beschreibt einen Halbleiterspeicher, der in einzelne Speicherfelder unterteilt ist, die jeweils von einem Blockdecoder angesteuert werden. Der Speicher besteht nicht aus einer Gate-Array Anordnung und es ist auch nicht dargestellt, wie die einzelnen Peripherieschaltungen zum Speicherfeld im Lay out des Speichers liegen.

Die Realisierung von Speichern unterschiedlicher Kapazität wurde bisher auf verschiedene Art erreicht. Für speichernde Strukturen kleiner Kapazität wurden bistabile Schaltungen verwendet. Diese sind aus mehreren Gattern zusammengesetzt und benötigen deshalb verhältnismäßig viele Grundzellen eines Gate Arrays zur Speicherung einer Informationseinheit. Speicher großer Kapazität wurden dadurch realisiert, daß ein als allgemeine Zelle entworfener Speicherblock definierter Kapazität in den Kernbereich des Chips eingebaut wurde. Dies führte dazu, daß die Kapazität eines Speichers nur in Schritten der Speicherkapazität dieser allgemeinen Zelle gewählt werden kann. Die für die allgemeinen Zellen reservierte Fläche kann somit nur für den Speicher verwendet werden, nicht für eine sonstige logische Funktion.

Die der Erfindung zugrundeliegende Aufgabe besteht darin, einen RAM-Speicher anzugeben, der unter Verwendung von Speicherzellen aus 7 Transistor-Grundzellen einen Speicher beliebiger Größe ermöglicht, wobei es besonders wichtig ist, daß das Lay out der einzelnen Speicherzellen und der Peripherieschaltungen derart ist, daß die Erweiterbarkeit eines Speichers bzw. die Anpassung der Größe des Speichers an Kundenanforderungen auf einfache Weise verwirklichbar ist.

Diese Aufgabe wird bei einem CMOS-RAM-Speicher der eingangs angegebenen Art entsprechend den Merkmalen des Patentanspruchs 1 gelöst.

Es werden somit zur Realisierung eines oder mehrerer Speicherfelder für jede Speicherzelle nur eine Grundzelle verwendet. Um die Speicherfelder herum werden dann die zur Auswahl, zum Lesen und Schreiben von Informationen erforderlichen Schaltungen angeordnet. Diese werden ebenfalls ausschließlich mit Hilfe der Grundzellen realisiert. Soll ein Speicherfeld hinzugefügt werden oder Speicherfeld vergrößert werden, dann ist dies auf einfache Weise möglich. Es müssen nur zusätzlich Grundzellen für die Speicherzellen vorgesehen werden, die entweder in einem bisherigen Speicherfeld angeordnet werden oder es wird ein ganzes Speicherfeld neben einem bisherigen Speicherfeld angefügt. Die Lage der für die Ansteuerung und Auswahl der Speicherzellen erforderlichen Schaltungen, die um die Speicherfelder herum gruppiert sind, wird dabei kaum berührt. Zu dem können die möglichen Speicherkonfigurationen frei gewählt werden. Wenn die maximale Speicherkapazität z.B. 16 K beträgt, dann kann die mögliche Speicherkonfiguration entweder 512 Worte mal 32 Bit bis 4096 mal 4 Bit betragen. Es ist zweckmäßig, die Wortbreite größer/gleich 4 Bit zu wählen, wobei die Wortbreite in 1 Bitstufen erweitert werden kann.

Weiterbildungen der Erfindung ergeben sich aus den Unteransprüchen.

Anhand von Ausführungsbeispielen, die in den Figuren dargestellt sind, wird die Erfindung weiter erläutert. Es zeigen

Fig. 1 eine Prinzipdarstellung eines RAM-Speichers,

Fig. 2 das Layout einer Grundzelle,

Fig. 3 den Stromlaufplan einer Speicherzelle,

Fig. 4 eine Ansteuerschaltung zur Erzeugung von Schreibsignalen,

Fig. 5 ein Wortleitungsdecoder zur Erzeugung von Wortleitungssignalen,

Fig. 6 ein Vordecoder, der aus einem Teil der Adressensignale Adressenzwischensignale für den Wortleitungsdecoder erzeugt,

Fig. 7 einen Blockdecoder zur Auswahl eines Speicherfeldes,

Fig. 8 eine Prinzipdarstellung der Anordnung von Schreib/Leseschaltungen,

Fig. 9 ein Stromlaufplan einer Schreib/Leseschaltung,

Fig. 10 das Layout einer Speicherzelle,

Fig. 11 den Stromlaufplan einer Ansteuerschaltung gemäß Fig. 4,

Fig. 12 das Layout der Ansteuerschaltung,

Fig. 13 ein Layout des Wortleitungsdecoders.

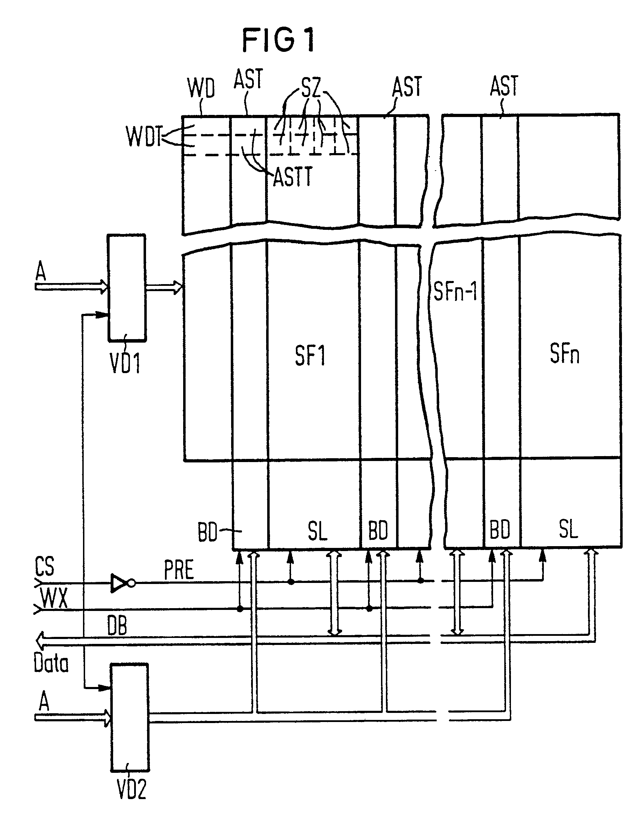

Nach Fig. 1 sind nebeneinander mehrere Speicherfelder SFI bis SFn angeordnet, die jeweils in Zeilen und Spalten, also matrixartig, Speicherzellen enthalten. Ein Speicherfeld kann z.B. aus m-Reihen (m = 4...64) zu nxK Spalten (n = 1...64, 4 ≤ K ≤ 32) (n × K ≤ 256) bestehen, wobei K die Datenwortbreite in Bit darstellt. Durch Veränderung der Anzahl von Zeilen kann somit die Kapazität des Speichers erhöht werden, eine Erhöhung der Kapazität ist auch möglich, wenn man zusätzliche Speicherfelder SF vorsieht.

Benachbart zu jedem Speicherfeld SF, und zwar in Zeilenrichtung gesehen, ist eine Ansteuerschaltung AST vorgesehen, die Schreibsignale erzeugt, wenn in das Speicherfeld Information eingeschrieben werden soll. Dazu erhält sie von einem Wortleitungsdecoder WD ein Wortleitungssignal, durch das eine bestimmte Wortleitung des Speichers (Zeile) ausgewählt wird und bei einer Mehrheit von Speicherfeldern von einem Blockdecoder BD ein Auswahlsignal zur Auswahl eines bestimmten Speicherfeldes SF. Der Wortleitungsdecoder WD ist pro Speicher nur einmal vorgesehen, ihm sind mehrere Speicherfel der zuordenbar. Die Auswahl eines bestimmten Speicherfeldes SF erfolgt dann über den Blockdecoder BD.

Dem Wortleitungsdeonder WD werden über einen Vordecoder VD1 Adressensignale A zugeführt, die ihm ermöglichen, die Wortleitung derjenigen Zeile auszuwählen, in die eine Information eingespeichert werden soll.

Die einzelnen Speicherfelder SF werden durch den Blockdecoder BD ausgewählt, dem zu diesem Zwecke ebenfalls Adressensignale A zugeführt werden, die über einen Vordecoder VD2 geführt worden sind.

In Spaltenrichtung gesehen liegen neben den Speicherfeldern SF die Scheibleseverstärkerschaltungen SL, die mit einem Datenbus DB verbunden sind. Über diesen Datenbus können den Speicherfeldern SF Informationen zugeführt werden, die in die Speicherzellen eingeschrieben werden sollen oder es können aus den Speicherfeldern ausgelesene Informationen abgegeben werden. Mit Hilfe eines Schreibauswahlsignales WX wird festgelegt, ob in den Speicher Information eingeschieben werden soll oder aus dem Speicher Information ausgelesen werden soll. Im Blockdecoder BD werden aus Adressensignalen das Speicherfeld ausgewählt und ein Auswahlsignal zum Schreiben bzw. ein Auswahlsignal zum Lesen erzeugt.

Schließlich ist noch ein Chipauswahlsignal CS vorgesehen, um den Speicher zu aktivieren/inaktivieren.

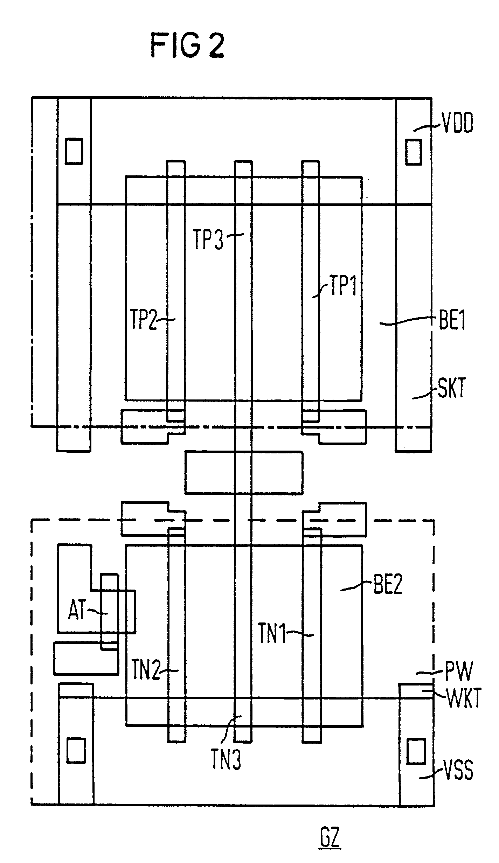

Die Speicherfelder SF, die Ansteuerschaltungen AST, der Wortleitungsdecoder WD, die Blockdecoder BD und die Schreibeleseverstärkerschaltungen SL sind mit Hilfe einer Grundzelle GZ realisiert, deren Layout Fig. 2 zeigt. Die Grundzelle enthält drei P-Kanaltransistoren TP1, TP2, TP3 und drei N-Kanaltransistoren TN1, TN2, TN3, die gleiche Kanalweite haben und deren Gateanschlüsse zwischen zwei Bereichen BE1, BE2 für die P-Kanaltransistoren und die N-Kanaltransistoren liegen. Benachbart zu den N-Kanaltransistoren TN1 bis TN3 liegt noch ein vierter N-Kanaltransistor AT, der eine kleinere Kanalweite hat als die übrigen N-Kanaltransistoren TN, Die Grundzelle wird auf beiden Seiten mit einer Leitung für die Versorgungsspannungen abgeschlossen, nämlich auf der Seite der P-Kanaltransistoren TP für die Versorgungspannung VDD, auf der Seite der N-Kanaltransistoren TN für die Versorgungsspannung VSS. Hingewiesen werden muß noch, daß die N-Kanaltransistoren TN in einer P-Wanne PW liegen, die über einen Wannenkontakt WKT mit der Versorgungsspannung VSS verbunden ist. Neben dem Bereich für die P-Kanaltransistoren TP sind Substratkontakte SKT angeordnet, die mit der Versorgungsspannung VDD verbunden sind.

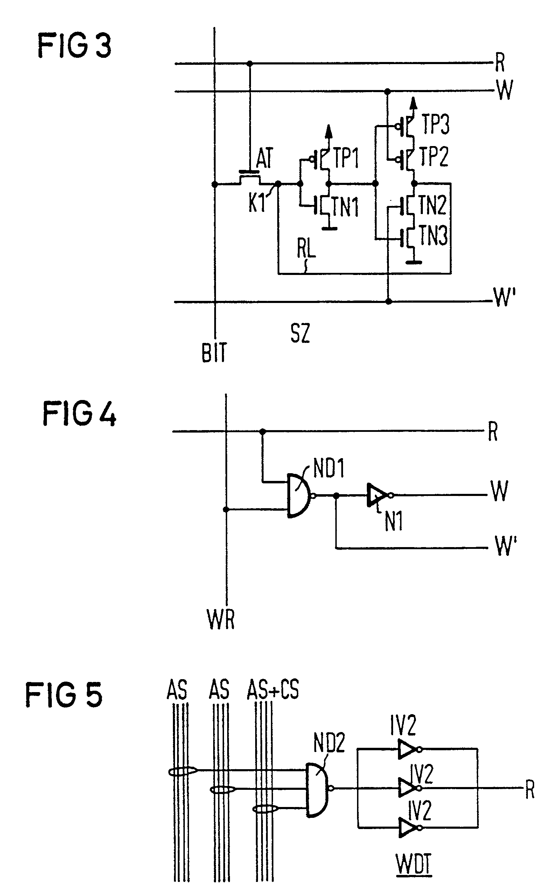

Mit Hilfe einer solchen 7 Transistor-Grundzelle kann nun eine Speiherzelle SZ gemäß Fig. 3 realisiert werden. Diese besteht aus einem Auswahltransistor AT und zwei rückgekoppelten Invertern. Der eine Inverter ist mit Hilfe der Transistoren TP1 und TN1 realisiert, der andere Inverter mit Hilfe der Transistoren TP2, TP3 und TN2 und TN3. Der Auswahltransistor AT ist zusätzlich mit einer Bitleitung BIT verbunden, seine Gateelektrode mit einer Leitung für das Wortleitungssignal R, die Gateelektrode des Transistors TP2 des zweiten Inverters ist mit dem Schreibsignal W, die Gateelektrode des korrespondierenden Transistors TN2 mit dem invertierten Schreibsignal W' verbunden.

Da bei Gate Arrays die Transistorweiten relativ groß vorgegeben sind, muß die Rückkopplungsleitung RL zum Beschreiben der Zelle hochohmig schaltbar sein. Der Auswahltransistor AT darf dabei nur eine beschränkte Weite besitzen, um ein unbeabsichtigtes Kippen der Zelle beim Lesen zu verhindern (schnelles Durchschalten des Auswahltransistors AT führt zu einer Umladung von der Bitleitung BIT auf den Eingangsknoten K1 der Zelle).

Die Funktion der Speicherzellen nach Fig. 3 wird kurz erläutert. Soll eine Information aus der Speicherzelle ausgelesen werden, dann wird das Wortleitungssignal R der Speicherzelle zugeführt und damit der Auswahltransistor AT leitend gesteuert. Da die Schreibsignale W = 'ϕ'' und W' = '1' anliegen, sind die Transistoren TP2 und TN2 durchgeschaltet, wodurch eine Änderung des Zustandes der Speicherzelle nicht möglich ist. Die Folge ist, daß sich die Bitleitung BIT auf das Potential am Knoten K1 umlädt. Wenn Information in die Speicherzelle eingeschrieben werden soll, dann werden durch die Schreibsignale W = '1', W' = 'ϕ' die Transistoren TP2, TN2 gesperrt. Der Auswahltransistor AT wird leitend gesteuert, wodurch der Knoten K1 auf Bitleitungspotential umgeladen wird. Ändert sich das Schreibsignal zu W = 'ϕ', W' = '1', dann gehen die Transistoren TP2, TN2 in den leitenden Zustand über und das Potential an K1 wird von der Speicherzelle aktiv aufrechterhalten. Anschließend kann das Wortleitungssignal R wieder abgeschaltet werden und der Auswahltransistor AT geht in den Sperrzustand über.

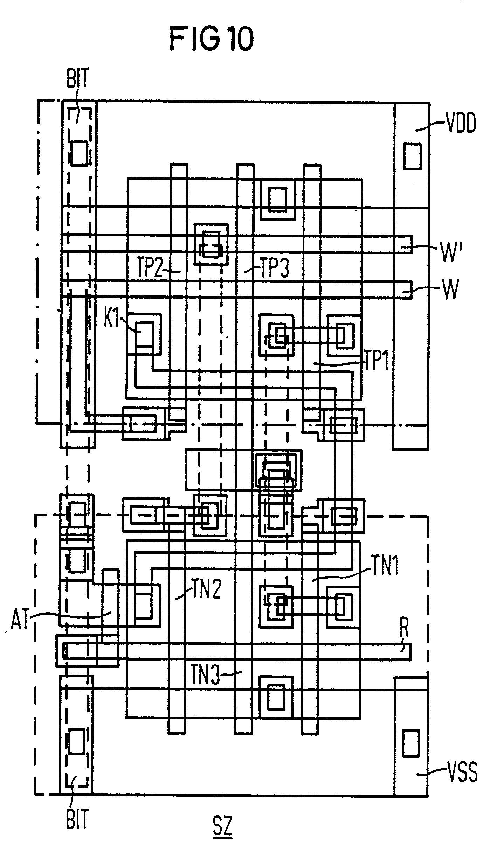

Fig. 10 zeigt das Layout einer Speicherzelle nach Fig. 3. Die einzelnen Transistoren sind entsprechend Fig. 3 gekennzeichnet, die einzelnen Leitungen mit dem Signal, das auf diesen Leitungen geführt wird. Es ist aus Fig. 10 leicht zu erkennen, wie die einzelnen Transistoren miteinander und mit den Leitungen für die Signale verbunden sind. Eine weitere Erläuterung der Fig. 10 bedarf es demgemäß nicht.

Aus Fig. 4 ergibt sich ein Ausschnitt aus einer Ansteuerschaltung AST. Diese sieht nämlich pro Zeile von Speicherzellen eines Speicherfeldes SF eine Ansteuerteilschaltung ASTT vor, die in Fig. 4 dargestellt ist. Sie besteht aus einem ersten NAND-Glied ND1, der das Wortleitungssignal R und ein Auswahlsignal WR vom Blockdecoder BD zugeführt wird. Das NAND-Glied ND1 ist mit einem Inverter IV1 verbunden, an dessen Ausgang das Schreibsignal W und an dessen Eingang das invertierte Schreibsignal W' abgegeben wird.

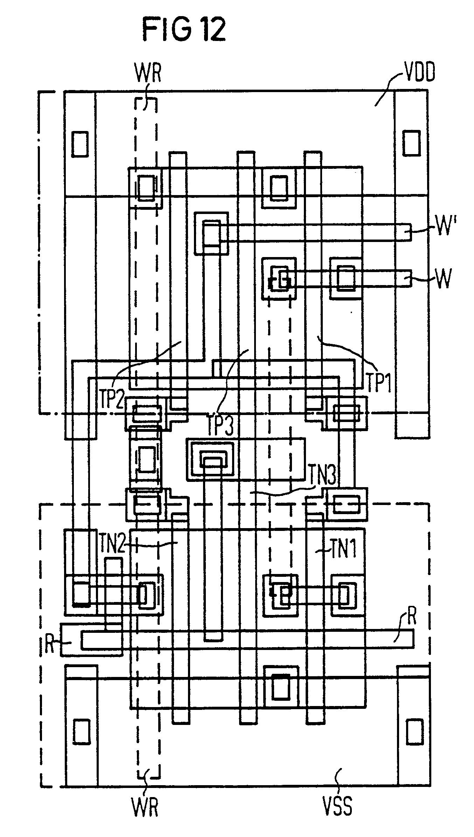

Jede Ansteuerteilschaltung gemäß der Fig. 4 kann mit Hilfe einer Grundzelle realisiert werden, wie dies in Fig. 12 dargestellt ist. Zur Verdeutlichung ist der Stromlaufplan des NAND-Gliedes ND1 und des Inverters IV1 in Fig. 11 gezeichnet. Die hier angegebenen Transistoren treten dann wieder im Layout der Fig. 12 auf. Die einzelnen Leitungen sind wiederum mit dem Signal bezeichnet, das sie führen. Auch hier kann aufgrund des Stromlaufplanes der Fig. 11 leicht das Layout der Ansteuerteilschaltung der Fig. 12 nachverfolgt werden. Die einzelnen Transistoren sind entsprechend Fig. 2 gekennzeichnet.

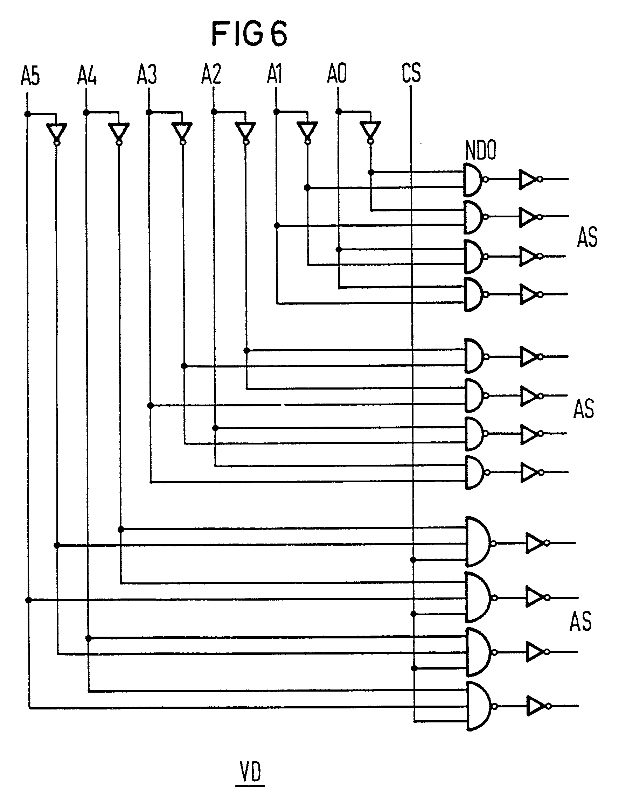

Der Wortleitungsdecoder WD, der für alle Speicherfelder SF nur einmal vorgesehen ist, enthält pro Zeile von Speicherzellen eine Decoderteilschaltung WDT, wie sie in Fig. 5 gezeigt ist. Diese Decoderteilschaltung bestimmt aus Adressensignalen AS die Wortleitung, in die eine Information eingeschrieben werden soll oder ausgelesen werden soll. Sie besteht aus einem NAND-Glied ND2, das mit Leitungen für die Adressensignale AS verbunden ist und aus Invertern IV2, die am Ausgang des NAND-Gliedes ND2 angeschlossen sind. Die Inverter IV2 sind parallel geschaltet und geben am Ausgang das Wortleitungssignal R ab.

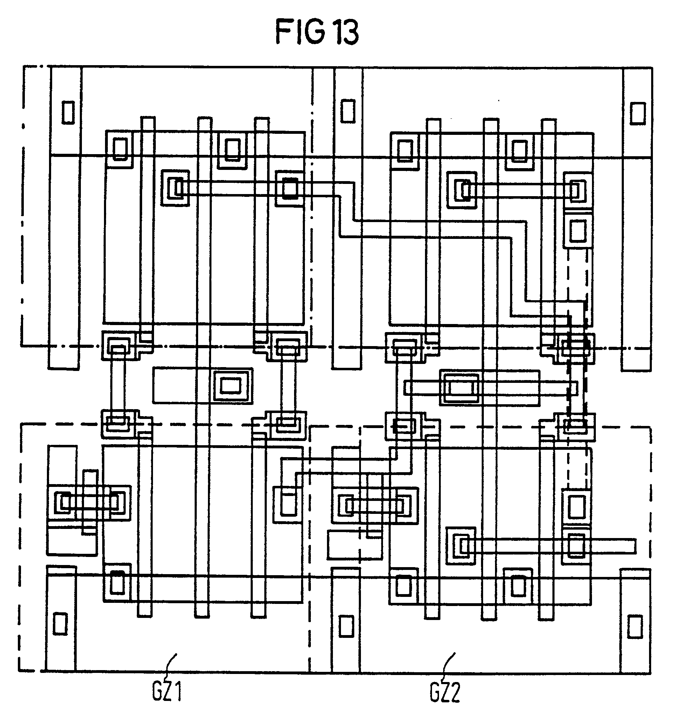

Eine solche Decoderteilschaltung kann mit Hilfe von zwei Grundzellen realisiert werden, wie dies Fig. 13 zeigt. Die erste Grundzelle GZ1 realisiert das dreifache NAND Glied ND2, die benachbart liegende Grundzelle GZ2 dreimal einen Inverter IV2. Hier ist der Stromlauf nicht gezeigt, er kann jedoch ohne Schwierigkeiten aus der Decoderteilschaltung nach Fig. 5 entwickelt werden.

Die Adressensignale A5, die den Decoderteilschaltungen WDT zugeführt werden, werden aus einem Teil der Adresse A durch einen Vordecoder VD1 entnommen. Ein Schaltbild eines solchen Vordecoders VD zeigt Fig. 6. Dem Vordecoder werden sechs Stellen einer Adresse A0 bis A5 und das Chipauswahlsignal CS zugeführt. Aus dieser Adresse erzeugt der Vordecoder VD auf übliche Weise die Adressensignale AS für den Wortleitungsdecoder WD. Dazu werden die Adressen invertiert und nicht invertiert NAND-Gliedern ND0 zugeführt, die entweder mit zwei Adreßeingängen oder mit zwei Adreßeingänge und der Leitung für das Chipauswahlsignal CS verbunden sind. Auf diese Weise erfolgt eine Vordecodierung der Adresse A, eine zweite weitere Decodierung erfolgt mit Hilfe des Wortleitungsdecoders WD.

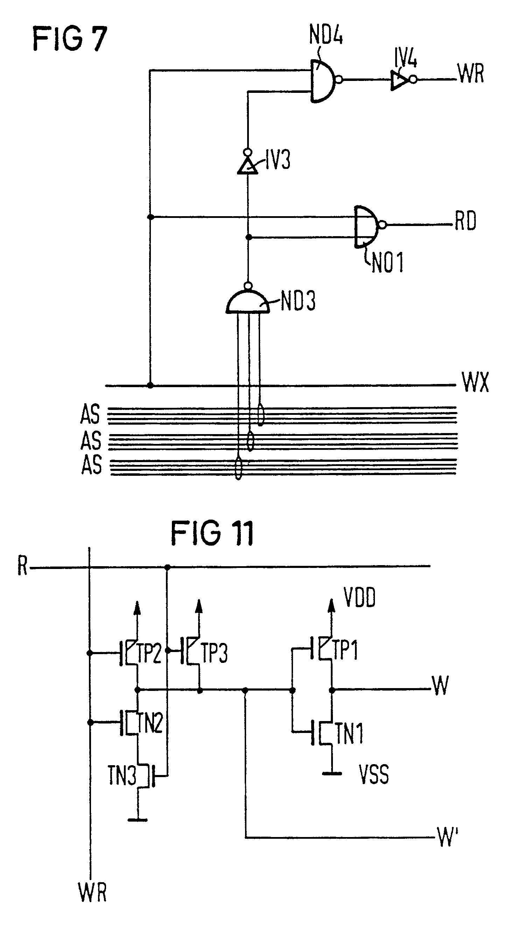

Wenn ein Speicher mehrere Speicherfelder enthält, dann muß pro Speicherfeld SF ein Blockdecoder BD vorgesehen werden, mit dessen Hilfe das einzelne Speicherfeld SF unter Verwendung eines zweiten Teiles der Adresse A ausgewählt wird. Ein solcher Blockdecoder ist in Fig. 7 dargestellt. Er besteht aus einem NAND-Glied ND1, das mit den Adressensignalen AS verbunden ist, aus einem NOR-Glied NO1, das mit dem Ausgang des NAND-Gliedes ND3 und mit der Leitung für das Schreibauswahlsignal WX verbunden ist und am Ausgang das Lesesignal RD abgibt und aus einem weiteren NAND-Glied ND4, das über einen Inverter IV3 mit dem Ausgang des NAND-Gliedes ND3 und mit der Leitung für das Schreibauswahlsignal WX verbunden ist und am Ausgang das Auswahlsignal WR nach Invertierung über einen Inverter IV4 abgibt. Der dargestellte Blockdecoder enthält seine Adressensignale AS über den Vordecoder VD2, der entsprechend Fig. 6 aufgebaut ist. Er kann mit Hilfe van vier Grundzellen GZ realisiert werden.

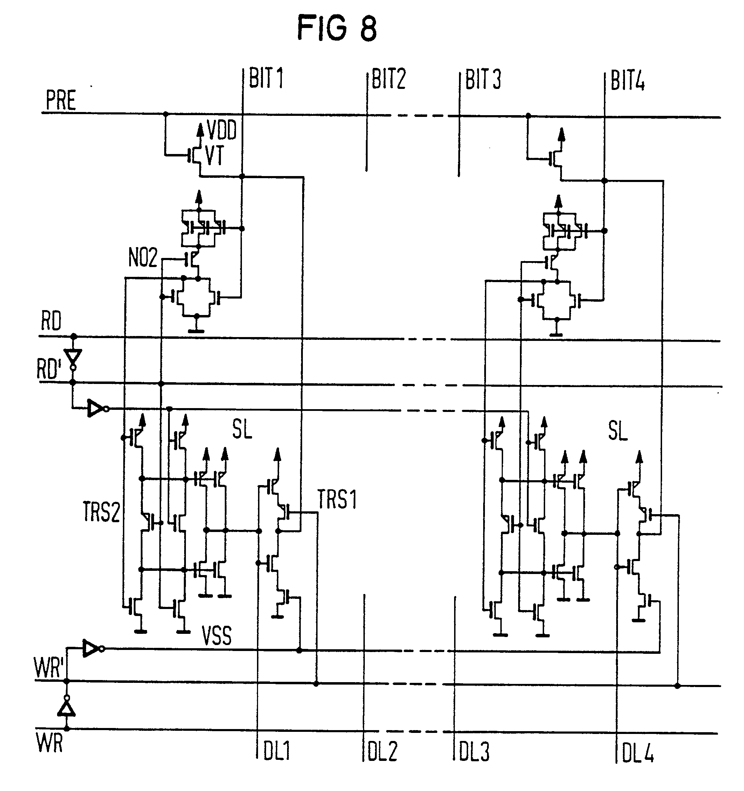

Die Schreibleseschaltung für vier Bit ist in Fig. 8 gezeigt. Pro Bitleitung ist eine Schreibleseschaltung SL notwendig, über die Information von einer Datenleitung DL zur Bitleitung BIT übertragen wird. Den Schreibleseschaltungen SL wird ein Vorladesignal PRE zugeführt. Weiterhin werden ihnen das Auswahlsignal WR und das Lesesignal RD zugeleitet. Die Schreibleseschaltung für vier Bit kann auf 4 × 4 GZ realisiert werden (einschließlich der Inverter für RD',

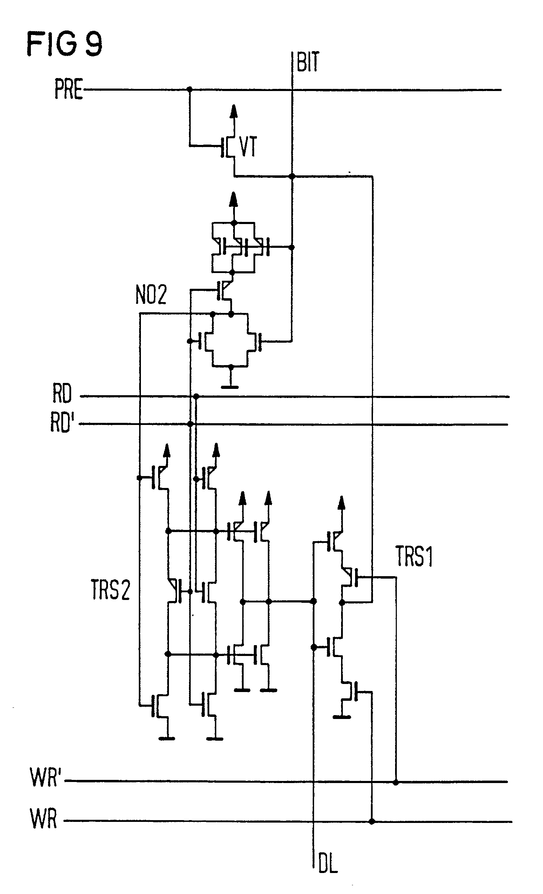

RD, WR', WR). Die Schreibleseschaltung ohne Inverter für das Auswahlsignal WR' und das Lesesignal RD' kann auf vier Grundzellen GZ realisiert werden. RD' und WR' muß dann zugeführt werden (Fig. 9).

Zum Schreiben werden Informationen vom Datenbus DB über eine Datenleitung DL einem Tristatetreiber TRS1 zugeführt. Dieser Tristatetreiber besteht aus zwei P-Kanal-Transistoren und zwei N-Kanaltransistoren. In Abhängigkeit der Information auf der Datenleitung DL wird an die Leitung BIT entweder das Potential H oder das Potential L angelegt. Dazu muß das Auswahlsignal WR = '1' anliegen.

Beim Lesen wird zunächst die Bitleitung über den Vorladetransistor VT vorgeladen, um von einem definierten Zustand zu Beginn des Lesevorganges auszugehen. Die Bewertung des Bitleitungspotentials übernimmt ein NOR-Glied NO2, dem auch das invertierte Lesesignal RD' zugeführt wird. Mit Hilfe des invertierten Lesesignals RD' wird das NOR-Glied NO2 gesperrt, wenn keine Information ausgelesen werden soll. Die Schaltschwelle des NOR-Gliedes NO2 ist durch Parallelschaltung mehrerer P-Kanaltransistoren gegen das Potential VDD verschoben, um eine Entladung der Bitleitung BIT schnell zu erkennen und damit die Zugriffszeit zu reduzieren.

Dem NOR-Glied NO2 ist ein Tristatetreiber TSR2 nachgeschaltet. Dieser legt ein Potential entsprechend dem Potential auf der Bitleitung BIT auf die Datenleitung DL. Dem Tristatetreibar TSR2 wird dazu das Lesesignal RD zugeleitet. Aus dem Stromlaufplan der Fig. 9 kann ohne Schwierigkeiten die Funktion der Schreib-Lese-Schaltung entnommen werden.

## Ansprüche

1. CMOS-RAM-Speicher auf einer Gate-Array-Anordnung, die eine Matrix aus Grundzellen aufweist, mit folgenden Merkmalen :

a) die Grundzellen (GZ) bestehen aus sieben Transistoren,

b) es ist mindestens ein Speicherfeld (SF) aus in Zeilen und Spalten angeordneten aus jeweils einer Grundzelle bestehenden Speicherzellen (SZ) vorgesehen, wobei die in einer Zeile der Speicherfelder liegenden Speicherzellen an einer Wortleitung liegen,

c) die Speicherzellen (SZ) sind durch ein Schreibsignal (W, W') auswählbar,

d) es ist pro Speicherfeld (SF) ein in Grundzellen realisierter Blockdecoder (BD) vorgesehen, der aus einer Adresse (A) für das zugeordnete Speicherfeld ein Auswahlsignal (WR) und ein Lesesignal (RD) erzeugt,

e) in Zeilenrichtung benachbart zu einem äußeren Speicherfeld ist ein Wortleitungsdecoder (WD) angeordnet, der pro Zeile von Speicherzellen aller Speicherfelder eine in Grundzellen realisierte Decoderteilschaltung (WDT) zur Erzeugung eines Wortleitungssignals (R) aus der Adresse (A) enthält, wobei das Wortleitungssignal über die Wortleitung allen in der Zeile liegenden Speicherzellen zugeführt wird,

f) in Zeilenrichtung benachbart zu jedem Speicherfeld (SF) ist eine Ansteuerschaltung (AST) angeordnet, die pro Zeile von Speicherzellen des benachbarten Speicherfeldes eine mit einer Grundzelle realisierte Ansteuerteilschaltung (ASTT) zur Erzeugung des Schreibsignales (W, W') für die zugeordnete Zeile von Speicherzellen des benachbarten Speicherfeldes aus dem Wortleitungssignal (R) und dem Auswahlsignal (WR) vorsieht,

g) in Spaltenrichtung ist benachbart jedem Speicherfeld (SF) eine in Grundzellen realisierte durch das Lesesignal (RD) auswählbare Schreib-Leseschaltung (SL) angeordnet,

h) der pro Speicherfeld zur Auswahl der in diesem Speicherfeld enthaltenen Speicherzellen vorgesehene Blockdecoder (BD) ist in Spaltenrichtung benachbart zu der Ansteuerschaltung (AST) dieses Speicherfeldes und benachbart zur Schreib-Leseschaltung (SL) dieses Speicherfeldes angeordnet.

2. CMOS-RAM-Speicher nach Anspruch 1, dadurch **gekennzeichnet**, daß die Ansteuerteilschaltung (ASTT) zur Realisierung mit einer Grundzelle (GZ) aus einem ersten NAND-Glied (ND1), dem das Wortleitungssignal (R) und das Auswahlsignal (WR) zugeführt wird und aus einem Inverter (IV1) besteht, der mit dem Ausgang des NAND-Gliedes (ND1) verbunden ist, an dessen Eingang das invertierte Schreibsignal (W') und an dessen Ausgang das nicht invertierte Schreibsignal (W) abgegeben wird.

3. CMOS-RAM-Speicher nach einem der vorhergehenden Ansprüche **gekennzeichnet** durch einen Wortleitungsdecoder (WD) mit mit Hilfe von zwei Grundzellen (GZ) realisierten Decoderteilschaltungen (WDT), die aus einem NAND-Glied (ND2), dem Adressensignale (AS) zugeführt werden, und aus mindestens einem Inverterglied (IV2) besteht, das mit dem Ausgang des NAND-Gliedes (ND2) verbunden ist und daß das Wortleitunassignal (R) abgibt.

4. CMOS-RAM-Speicher nach einem der vorhergehenden Ansprüche **gekennzeichnet** durch einen mit vier in Spaltenrichtung liegenden Grundzellen (GZ) realisierten Blockdecoder (BD) aus einem NAND-Glied (ND3), dem Adressensignale (AS) zugeführt werden, aus einem NOR-Glied (NO1), das mit dem Ausgang des NAND-Gliedes (ND3) verbunden ist und dem das Schreibauswahlsignal (WX) zugeführt wird und daß das Lesesignal (RD) abgibt, und aus einem weiteren NAND-Glied (ND4), daß über einen Inverter (IV3) mit dem Ausgang des NAND-Gliedes (ND3) verbunden ist und dem das Schreibauswahlsignal (WX) zugeführt wird und der das Auswahlsignal (WR) über ein Inverterglied (IV4) abgibt.

5. CMOS-RAM-Speicher nach einem der vorhergehenden Ansprüche **gekennzeichnet** durch eine mit vier in Spaltenrichtung angeordneten Grundzellen realisierten Schreib-Lese-Schaltung (SL)

    – aus einem zwischen einer Datenleitung (DL) und einer Bitleitung (BIT) angeordneten Tristatetreiber (TRS1) aus jeweils zwei in Serie liegenden N-Kanal-bzw.P-Kanaltransistoren, dem das Auswahlsignal (WR) invertiert und nicht invertiert zugeführt wird,

    – aus einem mit der Bitleitung (BIT) verbundenen NOR-Glied (NO2), dessen anderem Eingang das Lesesignal (RD) in invertierter Form zugeführt wird,

    – aus einem dem NOR-Glied (NO2) nachgeschalteten Tristatetreiber (TRS2), der das Lesesignal auf die Datenleitung (DL) überträgt.

## Revendications

1. Mémoire RAM-CMOS située sur un dispositif formé d'un réseau de portes, qui comporte une matrice de cellules de base, présentant les caractéristiques suivants :

    a) les cellules de base (GZ) sont constituées par sept transitors,

    b) il est prévu au moins une zone de mémoire (SF) formée par des cellules de mémoire (SZ) disposées suivant des lignes et des colonnes et constituées chacune par une cellule de base, les cellules de mémoire situées dans une ligne des zones de mémoire étant raccordées à une ligne de transmission de mots,

    c) les cellules de mémoire (SZ) peuvent être sélectionnées au moyen d'un signal d'enregistrement (W, W'),

    d) pour chaque zone de mémoire (SF) il est prévu un décodeur de blocs (BD), qui est formé dans des cellules de base et produit, à partir d'une adresse (A) pour la zone de mémoire associée, un signal de sélection (WR) et un signal de lecture (RD),

    e) au voisinage d'une zone extérieure de mémoire, dans la direction des lignes, est disposé un décodeur (WD) des lignes de transmission de mots, qui contient, pour chaque ligne de cellules de mémoire de toutes les zones de mémoire, un circuit partiel de décodage (WDT), formé dans des cellules de base et servant à produire un signal (R) de ligne de transmission de mots à partir de l'adresse (A), le signal de la ligne de transmission de mots étant envoyé, par la ligne de transmission de mots, à toutes les cellules de mémoire de la ligne,

    f) au voisinage de chaque zone de mémoire (SF) est disposé, dans la direction des lignes, un circuit de commande (AST), qui prévoit, pour chaque ligne de cellules de mémoire de la zone de mémoire voisine, un circuit partiel de commande (ASTT), qui est réalisé avec une cellule de base et sert à produire le signal d'enregistrement (W,W') pour la ligne associée de cellules de mémoire de la zone de mémoire voisine, à partir du signal (R) de la ligne de transmission de mots et du signal de sélection (WR),

    g) au voisinage de chaque zone de mémoire (SF) est disposé, dans la direction des colonnes, un circuit d'enregistrement-lecture (SL) formé dans des cellules de base et pouvant être sélectionné par le signal de lecture (RD),

    h) le décodeur de blocs (BD) prévu pour chaque zone de mémoire pour la sélection des cellules de mémoire contenues dans cette zone de mémoire est disposé, dans la direction des colonnes, au voisinage du circuit de commande (AST) de cette zone de mémoire et au voisinage du circuit d'enregistrement-lecture (SL) de cette zone de mémoire.

2. Mémoire RAM-CMOS suivant la revendication 1, caractérisée par le fait que le circuit partiel de commande (ASTT) destiné à être réalisé avec une cellule de base (GZ) est constitué par un premier circuit NON-ET (ND1), auquel sont envoyés le signal (R) de la ligne de transmission de mots et le signal de sélection (WR), et par un inverseur (IV1), qui est raccordé à la sortie du circuit NON-ET (ND1), et à l'entrée duquel est appliqué le signal d'enregistrement inversé (W'), tandis qu'à sa sortie est délivré le signal d'enregistrement non inversé (W).

3. Mémoire RAM-CMOS suivant l'une des revendications précédentes, caractérisée par un décodeur (WD) de la ligne de transmission de mots comportant des circuits partiels de décodage (WDT), qui sont formés de deux cellules de base (GZ) et sont constitués par un circuit NON-ET (ND2), auquel sont envoyés des signaux d'adresses (AS), et par au moins un circuit inverseur (IV2), qui est raccordé à la sortie du circuit NON-ET (ND2) et qui délivre le signal (R) de la ligne de transmission de mots.

4. Mémoire RAM-CMOS suivant l'une des revendications précédentes, caractérisée par un décodeur de blocs (BD) réalisé avec quatre cellules de base (GZ) situées dans la direction des colonnes est constitué par un circuit NON-ET (ND3), auquel sont envoyés des signaux d'adresses (AS), un circuit NON-OU (NO1), qui est relié à la sortie de la porte NON-ET (ND3) et auquel est envoyé le signal de sélection d'enregistrement (WX), et qui délivre le signal de lecture (RD), et par un autre circuit NON-ET (ND4), qui est raccordé par l'intermédiaire d'un inverseur (IV3) à la sortie du circuit NON-ET (ND3) et auquel est envoyé le signal de sélection d'enregistrement (WX) et qui délivre le signal de sélection (WR) par l'intermédiaire d'un circuit inverseur (IV4).

5. Mémoire RAM-CMOS suivant l'une des revendications précédentes, caractérisée par un circuit d'enregistrement-lecture (SL) réalisé avec quatre cellules de base disposées dans la direction des colonnes et constitué

– par un étage d'attaque trois-états (TRS1) disposé entre une ligne de transmission de données (DL) et une ligne de transmission de bits (BIT) et constitué par deux transistors respectifs à canal N ou P, branchés en série, et auquel le signal de sélection (WR) est envoyé sous forme inversée et sous forme non inversée,

– par un circuit NON-OU (NO2), qui est raccordé a la ligne de transmission de bits (BIT) et à l'autre entrée duquel le signal de lecture (RD) est envoyé sous forme inversée,

– par un étage d'attaque trois-états (TRS2), qui est branché en aval du circuit NON-ET (NO2) et transmet le signal de lecture à la ligne de transmission de données (DL).

## Claims

1. CMOS-RAM memory based on a gate array arrangement which has a matrix of basic cells, characterised in that :

a) the basic cells (GZ) are composed of seven transistors,

b) at least one memory area (SF) made up of memory cells (SZ) arranged in rows and columns and each composed of a basic cell is provided, the memory cells situated in one row of the memory areas being connected to a word line,

c) the memory cells (SZ) can be selected by means of a write signal (W, W'),

d) a block decoder (BD) which can be realised in basic cells and which generates a selection signal (WR) and a read signal (RD) from an address (A) for the associated memory area is provided for each memory area (SF),

e) disposed adjacently to an external memory area in the row direction is a word line decoder (WD) which contains, for every row of memory cells of all the memory areas, a decoder subcircuit (WDT), realised in basic cells, for generating a word line signal (R) from the address (A), the word line signal being fed to all the memory cells situated in the row via the word line,

f) disposed adjacently to every memory area (SF) in the row direction is a drive circuit (AST) which provides, for every row of memory cells of the adjacent memory area, a drive subcircuit (ASTT), realised with a basic cell, for generating the write signal (W, W') for the associated row of memory cells of the adjacent memory signal (WR),

g) disposed adjacently to every memory area (SF) in the column direction is a write/read circuit (SL) which is realised in basic cells and can be selected by the read signal (RD),

h) the block decoder (BD) provided for every memory area for selecting the memory cells contained in that memory area is disposed in the column direction adjacently to the drive circuit (AST) of said memory area and adjacently to the write/read circuit (SL) of said memory area.

2. CMOS-RAM memory according to Claim 1 characterised in that the drive subcircuit (ASTT) is composed, for the purpose of realisation with a basic cell (GZ), of a first NAND element (ND1) to which the word line signal (R) and the selection signal (WR) are fed and of an inverter (IV1) which is connected to the output of the NAND element (ND1) at whose input the inverted write signal (W') is supplied and at whose output the non-inverted write signal (W) is supplied.

3. CMOS-RAM memory according to one of the preceding claims, characterised by a word line decoder (WD) which has decoder subcircuits (WDT) realised with the aid of two basic cells (GZ) and which is composed of a NAND element (ND2), to which address signals (AS) are fed, and of at least one inverter element (IV2) which is connected to the output of the NAND element (ND2) and which supplies the word line signal (R).

4. CMOS-RAM memory according to one of the preceding claims, characterised by a block decoder (BD) realised with four basic cells (GZ) situated in the column direction and composed of a NAND element (ND3) to which address signals (AS) are fed, of a NOR element (NO1) which is connected to the output of the NAND element (ND3) and to which the write selection signal (WX) is fed and which supplies the read signal (RD), and of a further NAND element (ND4) which is connected to the output of the NAND element (ND3) via an inverter (IV3) and to which the write selection signal (WX) is fed and which supplies the selection signal (WR) via an inverter element (IV4).

5. CMOS-RAM memory according to one of the preceding claims, characterised by a read/write circuit (SL) realised with four basic cells disposed in the column direction and composed

– of a tristate driver (TRS1) which is disposed between a data line (DL) and a bit line (BIT) and which is composed in each case of two n-channel or p-channel transistors situated in series and to which the selection signal (WR) is fed in inverted and non-inverted form,

– of a NOR element (NO2) which is connected to the bit line (BIT) and to whose other input the read signal (RD) is fed in inverted form,

– and of a tristate driver (TRS2) which follows the NOR element (NO2) and which transmits the read signal onto the data line (DL).

# FIG 1

# FIG 2

VDD

TP3

TP1

TP2

BE1

SKT

BE2

AT

TN1

TN2

PW
WKT

TN3

VSS

GZ

**FIG 3**

BIT

SZ

**FIG 4**

WR

**FIG 5**

WDT

# FIG 6

VD

# FIG 7

# FIG 11

# FIG 8

EP 0 359 743 B1

FIG 9

14

# FIG 10

BIT

VDD

W'

TP2 — | — TP3

W

K1

TP1

AT

TN1

TN2

R

TN3

VSS

BIT

SZ

# FIG 12

# FIG 13

GZ1          GZ2